# EUROPÄISCHE PATENTSCHRIFT

(11) **EP 1 238 575 B1**
(45) Veröffentlichungstag und Bekanntmachung des Hinweises auf die Patenterteilung: **03.08.2005**
(21) Anmeldenummer: 00993480.3
(22) Anmeldetag: 12.12.2000
(51) Int. Cl.: H05K 13/00

(54) **BESTÜCKVORRICHTUNG MIT MEHREREN TRANSPORTSTRECKEN FÜR ZU BESTÜCKENDE SUBSTRATE**
ASSEMBLY DEVICE COMPRISING SEVERAL TRANSPORT LINES FOR SUBSTRATES TO BE ASSEMBLED
DISPOSITIF DE MISE EN PLACE DE COMPOSANTS COMPRENANT PLUSIEURS LIGNES DE TRANSPORT POUR LES SUBSTRATS DEVANT RECEVOIR LES COMPOSANTS

(30) Priorität: 16.12.1999 DE 19960799
(43) Veröffentlichungstag der Anmeldung: 11.09.2002
(73) Patentinhaber: SIEMENS AKTIENGESELLSCHAFT, 80333 München (DE)
(72) Erfinder: MEHDIANPOUR, Mohammad, 81829 München (DE); BARNOWSKI, Frank, 81371 München (DE)
(86) Internationale Anmeldenummer: PCT/DE2000/004418
(87) Internationale Veröffentlichungsnummer: WO 2001/045482

(56) Entgegenhaltungen:
- EP-A- 0 302 542
- EP-A- 0 413 098
- WO-A-99/59389
- US-A- 2 890 456

## Beschreibung

Die Erfindung bezieht sich auf eine Bestückvorrichtung zum Bestücken von Substraten mit elektrischen Bauelementen, wobei die Substrate in zumindest einer Transportstrecke einer oberen Ebene zu einem Bestückplatz und von diesem weg transportierbar sind und wobei unterhalb der Transportstrecke Einbauplätze für zusätzliche Förderstrecken für die Substrate vorgesehen sind.

Durch die EP 0 413 089 A ist eine Durchlaufanlage zum Behandeln von Stückgütern bekannt geworden, bei der in Abschnitten mit großem Zeitbedarf mehrere Behandlungsstrecken parallel zueinander angeordnet werden, auf die die Stückgüter aufgeteilt werden.

Eine Bestückvorrichtung mit zusätzlichen Förderstrecken für die Substrate ist zum Beispiel durch die WO99/59389 A bekannt geworden. Danach sollen durch die zusätzlichen Förderstrecken lange Montagelinien in mehrere Abschnitte unterteilt werden, in denen jeweils eine Leiterplatte vollständig bestückt werden kann. Dabei ist vorgesehen, unterhalb einer Bestückstrecke eine zusätzliche Transportebene einzuführen, in der zwei nebeneinander liegende Förderstrecken der Zuführung der Substrate zu den Teilabschnitten bzw. der Abführung der fertig bestückten Substrate von den Teilabschnitten dienen. Vor und nach den Teilabschnitten sind Übergabeeinrichtungen angeordnet, durch die die Substrate zwischen den verschiedenen Strecken übergeben werden können. Das bedeutet, daß die Übergabeeinrichtung nicht nur in der Höhe, sondern auch seitlich verfahrbar sein muß, was mit entsprechend hohem Antriebs- und Führungsaufwand verbunden ist.

Insbesondere bei breiten Leiterplatten muß für die beiden Förderstrecken eine Einbaubreite vorgesehen werden, die zu einer Vergrößerung der Baubreite der Bestückvorrichtung und damit zur Vergrößerung der Standfläche führt. Damit vergrößert sich auch der Abstand zwischen dem Bestückfeld und den peripher bereitgestellten Zuführeinrichtungen für die elektrischen Bauteile. Die Verfahrwege eines Bestückkopfes werden entsprechend größer, wodurch die Bestückleistung sinkt.

Der Erfindung liegt die Aufgabe zugrunde, den Raumbedarf und den Vorrichtungsaufwand zu verringern.

Diese Aufgabe wird durch die Erfindung gemäß Anspruch 1 gelöst.

Durch die Anordnung der beiden Förderstrecken in zwei unmittelbar senkrecht übereinanderliegenden Ebenen brauchen die Übergabeeinrichtungen nur noch in einer Richtung verfahren zu werden, wodurch sich der konstruktive Aufwand verringert. Da die Substrate als flache Leiterplatten üblicherweise eine geringe Bauhöhe aufweisen, kann der Abstand zwischen den Förderstrecken klein gehalten werden, so daß die Verfahrwege erheblich kürzer sind als bei einer seitlichen Verschiebung. Die Einbaubreite für die Förderstrecken kann nahezu halbiert werden, wodurch die Bestückvorrichtung entsprechend kompakt ausgebildet werden kann.

Die Form des Chassis ergibt eine einfache, gießtechnisch unschwierig herzustellende Struktur von hoher Steifigkeit und Schwingungsfestigkeit.

Der Träger ermöglicht eine externe Montage der Förderstrecken einschließlich aller Antriebe, Stellmittel und Steuerungen. Es ergibt sich ein vollständig vorgefertigtes Fördermodul, das in einfacher Weise in den zur Verfügung gestellten Freiraum eingeschoben werden kann. Dabei ist es vorteilhaft, die Stützlager an beiden Stirnseiten der Bestückvorrichtung anzuordnen, so daß der Träger an gut zugänglichen Stellen befestigt werden kann.

Durch die Querverbindungsteile kann das Chassis der Bestückvorrichtung in unmittelbarer Nähe der Bestückebene stabilisiert werden, so daß die Bestückgenauigkeit auch bei einem relativ großen Freiraum für die Förderstrecken nicht beeinträchtigt wird. Die Querverbindungsteile können zugleich als Auflagen für die Transportstrecke bzw. für einen Bestücktisch der Transportstrecke dienen.

Vorteilhafte Weiterbildungen der Erfindung sind in den Unteransprüchen gekennzeichnet:

Die kurzen Höhenabstände zwischen den verschiedenen Strecken ergeben kurze Verfahrwege, so daß die Übergabemittel nach Anspruch 2 schnell zwischen den verschiedenen Ebenen verfahren werden können.

Durch die Weiterbildung nach Anspruch 3 ist es möglich, gewendete Substrate innerhalb der Bestückvorrichtung zum Anfang einer Bestücklinie raumsparend zurück zu transportieren und zur Bestückung der zweiten Substratseite erneut durch die Bestücklinie hindurch zu führen. Sämtliche Förderstrecken einschließlich der Rückführstrecke können in einer einheitlichen kompakten Anordnung zusammengefaßt und von den Übergabeeinrichtungen bedient werden. Dabei ist für die Rückführstrecke nur eine zusätzliche Förderstrecke erforderlich und muß der Hub der Übergabemittel lediglich geringfügig erhöht werden.

Die Revisionsöffnung nach Anspruch 4 ermöglicht den Zugang zu den Förderstrecken im Falle einer Störung.

Der kanalartige Querschnitt des Trägers nach Anspruch 5 ergibt eine formstabile Tragstruktur bei geringem Herstellaufwand.

Im folgenden wird die Erfindung anhand eines in der Zeichnung dargestellten Ausführungsbeispieles näher erläutert.
Figur 1 zeigt schematisiert einen Längsschnitt durch zwei unmittelbar aufeinanderfolgende Bestückvorrichtungen mit Übergabeeinrichtungen,
Figur 2 einen Querschnitt durch die Bestückvorrichtung nach Figur 1.

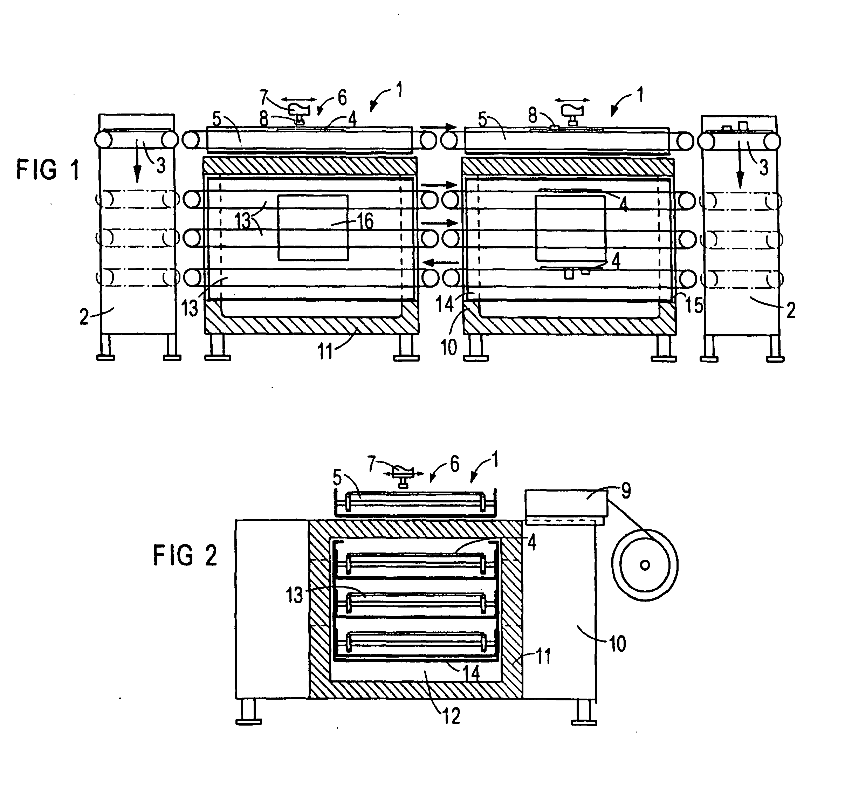

Nach den Figuren 1 und 2 sind zu beiden Seiten zweier aufeinanderfolgender Bestückvorrichtungen 1 Übergabeeinrichtungen 2 angeordnet, die mit in ihrer Höhe verfahrbaren Übergabemitteln 3 für Substrate 4 versehen sind. Die Bestückvorrichtung 1 weist in einer oberen Bestückebene eine Transportstrecke 5 auf, in deren mittleren Bereich ein Bestückplatz 6 angeordnet ist, über dem ein Bestückkopf 7 in zwei Koordinatenrichtungen verfahrbar ist. Der Bestückkopf 7 dient dazu, elektrische Bauelemente 8 von Zuführeinrichtungen 9 abzuholen und auf das Substrat 4 aufzusetzen.

Die Bestückvorrichtung 1 weist ein Chassis 10 auf, das unterhalb der Transportstrecke 5 als Chassisteil 11 von rechteckigem rohrförmigen Querschnitt ausgebildet ist. Das an beiden Enden offene Chassisteil 11 bildet einen Freiraum 12 mit Einbauplätzen für Förderstrecken 13, die senkrecht unterhalb der Transportstrecke 5 und parallel zu dieser verlaufen. Die Übergabemittel 3 sind in senkrechter Richtung zwischen der Transportstrecke 5 und den Förderstrecken 13 verfahrbar und können die Substrate 4 in die verschiedenen Strecken einschleusen bzw. aus diesen ausschleusen.

Es sind drei übereinanderliegende Förderstrecken vorgesehen, von denen die oberste als Zuführstrecke für die unbestückten Substrate, die mittlere als Abführstrecke für die fertig bestückten Substrate 4 und die unterste als Rückführstrecke für einseitig bestückte Substrate 4 dienen, die zur Bestückung der zweiten Substratseite gewendet in die Transportstrecke 5 eingeschleust werden können.

Das Chassisteil 11 weist seitliche Revisionsöffnungen 14 auf, durch die im Falle einer Störung die inneren Abschnitte der Förderstrecken 13 zugänglich sind. Die Förderstrecken 13 sind in einem U-förmig gebogenen Träger 14 gehalten, der mitsamt der vormontierten Förderstrecken 13 in den Freiraum 12 longitudinal einschiebbar ist. Der Träger 14 ist auf Stützlagern 15 an beiden Stirnseiten des Chassis 10 befestigt. Die Transportstrecke 5 ist auf der Oberseite des rohrförmigen Chassisteils 11 angebracht, so daß sich die obere Rohrwand zwischen der Transportstrecke 5 und der darunterliegenden Förderstrecke 13 befindet.

## Patentansprüche

1. Bestückvorrichtung (1) zum Bestücken von Substraten (4) mit elektrischen Bauelementen (8),
wobei die Substrate (4) in zumindest einer Transportstrecke (5) einer oberen Ebene zu einem Bestückplatz (6) und von diesem weg transportierbar sind und
wobei unterhalb der Transportstrecke (5) Einbauplätze für zusätzliche Förderstrecken (13) für die Substrate vorgesehen sind,
**dadurch gekennzeichnet, dass**
- die Einbauplätze für die Förderstrecken (13) in zumindest zwei übereinander liegenden Förderebenen angeordnet sind,
- die Bestückvorrichtung (1) ein sich in der Förderrichtung erstreckendes rohrförmiges Chassisteil (11) mit rechteckigem Querschnitt aufweist, wobei eine obere Rohrwand des Chassisteils (11) Querverbindungsteile bildet, die zwischen der Transportstrecke (5) und den Förderstrecken (13) angeordnet sind,
- die Transportstrecke (5) auf der oberen Rohrwand angebracht ist und der Hohlraum des Chassisteils (11) unterhalb der Querverbindungsteile zumindest einen in der Längsrichtung durchgehenden Freiraum (12) für die Förderstrecken (13)ausbildet,
- das Chassisteil (11) Stützlager (15) für einen Träger (14) aufweist, an dem die Förderstrecken (13) befestigbar sind, und
- der Träger mit den daran befestigten Förderstrecken (13) in der Transportrichtung in den Freiraum (12) einschiebbar ist.

2. Bestückvorrichtung nach Anspruch 1,
**dadurch gekennzeichnet, dass**
- eine Montagelinie mit einer Mehrzahl der Bestückvorrichtungen (1) für die Substrate (4) in mehrere Teilabschnitte unterteilt ist, in denen die Substrate (4) jeweils vollständig bestückbar sind, und
- zumindest zu beiden Seiten jedes Teilabschnittes Übergabeeinrichtungen (2) angeordnet sind, die zwischen den verschiedenen Strecken senkrecht verfahrbare Übergabemittel (3) für die Substrate aufweisen.

3. Bestückvorrichtung nach Anspruch 1 oder 2
**dadurch gekennzeichnet, dass** eine der Förderstrecken als Rückführstrecke für bereits einseitig bestückte Substrate betreibbar ist.

4. Bestückvorrichtung nach einem der vorhergehenden Ansprüche,
**dadurch gekennzeichnet, dass** das Chassisteil (11) mit zumindest einer längsseitigen Revisionsöffnung (16) versehen ist.

5. Bestückvorrichtung nach einem der vorhergehenden Ansprüche,
**dadurch gekennzeichnet, dass** der Träger (14) aus einem kanalartig U-förmig gebogenen Tragblech besteht.

## Claims

1. Apparatus (1) for fitting electrical components (8) on substrates (4), it being possible for the substrates (4), in at least one transporting section (5) of a top level, to be transported to a component-fitting location (6) and away from the same, and installation locations for additional conveying sections (13) for the substrates being provided beneath the transporting section (5), **characterized in that**
- the installation locations for the conveying sections (13) are arranged on at least two conveying levels located one above the other,
- the component-fitting apparatus (1) has a tubular chassis part (11) with a rectangular cross section which extends in the conveying direction, a top tube wall of the chassis part (11) forming transverse connecting parts which are arranged between the transporting section (5) and the conveying sections (13),
- the transporting section (5) is provided on the top tube wall and the cavity of the chassis part (II) forms at least one longitudinally continuous free space (12) for the conveying sections (13) beneath the transverse connecting parts,
- the chassis part (11) has supporting bearings (15) for a carrier (14) on which the conveying sections (13) can be fastened, and
- the carrier, with the conveying sections (13) fastened thereon, can be pushed into the free space (12) in the transporting direction.

2. Component-fitting apparatus according to Claim 1,
**characterized in that**
- an assembly line with a plurality of the component-fitting apparatuses (1) for the substrates (4) is subdivided into a plurality of sub-segments in which the substrates (4) are fitted out completely in each case, and
- arranged at least on both sides of each sub-segment are transfer arrangements (2) which have transfer means (3), for the substrates, which can be displaced vertically between the various sections.

3. Component-fitting apparatus according to Claim 1 or 2, **characterized in that** one of the conveying sections can be operated as a return section for substrates which have already been fitted out on one side.

4. Component-fitting apparatus according to one of the preceding claims, **characterized in that** the chassis part (11) is provided with at least one longitudinal-side inspection opening (16).

5. Component-fitting apparatus according to one of the preceding claims, **characterized in that** the carrier (14) comprises a load-bearing metal sheet which is bent in the form of a U in a channel-like manner.

## Revendications

1. Dispositif de pose (1) pour équiper des substrats (4) de composants électriques (8), les substrats (4) étant transportables sur au moins une ligne de transport (5) d'un niveau supérieur vers un emplacement de pose (6) et au départ de celui-ci et des emplacements pour le montage de lignes de convoyage (13) supplémentaires pour les substrats étant prévus en dessous de la ligne de transport (5),
**caractérisé en ce que**
- les emplacements pour le montage des lignes de convoyage (13) sont disposés dans au moins deux plans de convoyage superposés,
- le dispositif de pose (1) comporte une partie de châssis (11) de forme tubulaire de section rectangulaire qui s'étend dans la direction du convoyage, une paroi tubulaire supérieure de la partie de châssis (11) constituant des parties d'assemblage transversal qui sont situées entre la ligne de transport (5) et les lignes de convoyage (13),
- la ligne de transport (5) est placée sur la paroi tubulaire supérieure et l'espace creux de la partie de châssis (11) forme, en dessous des parties d'assemblage transversal, au moins un espace libre (12), continu dans le sens longitudinal, pour les lignes de convoyage (13),
- la partie de châssis (11) comporte des paliers supports (15) pour un support (14) auquel les lignes de convoyage (13) peuvent être fixées et
- le support avec les lignes de convoyage (13) qui y sont fixées peut être glissé dans l'espace libre (12) dans le sens du transport.

2. Dispositif de pose selon la revendication 1,
**caractérisé en ce que**
- une ligne de montage avec une pluralité des dispositifs de pose (1) pour les substrats (4) est subdivisée en plusieurs sections dans lesquelles les substrats (4) peuvent chacun être entièrement équipés et
- des équipements de transfert (2) sont situés au moins des deux côtés de chaque section, lesquels équipements comportent des moyens de transfert (3), pour les substrats, déplaçables verticalement entre les différentes lignes.

3. Dispositif de pose selon la revendication 1 ou 2,
**caractérisé en ce que** l'une des lignes de convoyage peut être exploitée en tant que ligne de retour pour des substrats déjà équipés d'un côté.

4. Dispositif de pose selon l'une des revendications précédentes,
**caractérisé en ce que** la partie de châssis (11) est pourvue d'au moins une ouverture d'inspection (16) sur le grand côté.

5. Dispositif de pose selon l'une des revendications précédentes,
**caractérisé en ce que** le support (14) se compose d'une tôle porteuse en forme de canal, pliée en forme de U.
